# EUROPEAN PATENT SPECIFICATION

(11) **EP 2 925 831 B1**
(45) Date of publication and mention of the grant of the patent: **29.03.2017**
(21) Application number: 13786629.9
(22) Date of filing: 04.11.2013
(51) Int. Cl.: C09K 11/02, C09K 11/06, C09K 11/82, H01L 31/055

(54) **WAVELENGTH CONVERSION POLYMER FILM**
WELLENLÄNGENUMWANDLUNGSPOLYMERFOLIE
FILM POLYMÈRE DE CONVERSION DE LONGUEURS D'ONDE

(30) Priority: 30.11.2012 EP 12008056
(43) Date of publication of application: 07.10.2015
(73) Proprietor: Merck Patent GmbH, 64293 Darmstadt (DE)
(72) Inventor: OKURA, Hiroshi, Hiratsuka-shi Kanagawa 254-0821 (JP); WAKIMOTO, Takeo, Minato-ku Tokyo 108-0014 (JP); MATSUI, Katsuyuki, Tokyo 183-0035 (JP); MATSUDA, Noriyuki, Chiba-shi Chiba 261-0011 (JP); SUZUKI, Masayoshi, Tokyo 151-0062 (JP); KISHIMOTO, Tadashi, Sagamihara-shi, Kanagawa 252-0143 (JP)
(86) International application number: PCT/EP2013/003307
(87) International publication number: WO 2014/082703

(56) References cited:
- EP-A2- 2 135 916
- WO-A1-2012/140542
- US-A1- 2012 060 897
- US-A1- 2012 119 639

## Description

### TECHNICAL FIELD OF THE INVENTION

The invention relates to a polymer film comprising an inorganic fluorescent compound and an organic fluorescent compound. The invention further relates methods for preparing such a film, and to its use as wavelength conversion film in a solar cell.

### BACKGROUND OF THE INVENTION

A semiconductor solar cell for obtaining electric energy by photoelectric conversion of a solar light is mainly an inorganic solar cell employing, for example, single crystal silicon (c-Si) or amorphous silicon (a-Si). During the last decade, its photoelectric conversion efficiency has been raised to a maximum of about 30%. This relatively small efficiency is mostly caused by the spectrum mismatch regarding the absorption wavelength range of the semiconductor material such as single crystal silicon or amorphous silicon and the solar irradiation spectra ranging mainly from 200 to 1200 nm. In this regard, the main absorption of solar irradiation occurs at wavelengths higher than 600 nm for an amorphous silicon based solar cell, or 800 nm for a single crystal silicon based solar cells, and which restricts the utilized radiation for the photoelectric conversion to the radiation of the longer wavelengths region of 600 nm or more.

Allowing the light in a short wavelength region of the solar light, which has also a high energy, to be utilized effectively, an attempt was made to employ for example rare earth metal ions, rare earth metal complex, fluorescent pigments, etc. to convert the radiation of a wavelength lower than 500 nm to radiation having a wavelength higher than 500 nm, and which than can be subjected to the photoelectric conversion process by the solar cell.

In this regard, WO 2010-01703 A1 discloses for example a wavelength conversion film containing a rare earth metal complex based fluorescent substance, which is used as one of the light-transmitting layers in a solar battery module comprising a plurality of light-transmitting layers and solar battery cells. The wavelength conversion film is characterized in that the fluorescent substance is composed of coated fluorescent substance particles, each having a fluorescent substance particle and a coating layer covering the surface of the fluorescent substance particle.

JP 2010-258293 A1 discloses a wavelength conversion film, for example, based on a rare earth metal complex fluorophore, capable of increasing the light utilization efficiency and improving the power-generating efficiency, by being constituted to reduce sunlight loss due to spectrum mismatch and to have a higher visible light transmittance rate. Furthermore, a solar cell module using the same is disclosed.

JP 2010-258293 A1 discloses a wavelength conversion film containing a fluorescent substance based on a rare earth metal complex. The fluorescent substance is a coated fluorescent substance having fluorescent substance particles and a coat layer covering the periphery of the fluorescent substance particles with a material having a refractive index lower than that of the fluorescent substance particles. Such a fluorescent substance is provided as a wavelength conversion film or was dispersed in an existing transparent electrode or antireflection film, or was provided as a cover sheet, thereby attempting to achieve its effectiveness.

JP 05156244 A1 discloses a fluorescent composition which comprises an amorphous fluororesin which is transparent and soluble in perfluoro-hydrocarbon solvents and a perfluoroalkyl-substituted derivative of a fluorescent condensed polycyclic aromatic compound for example, perfluoropropylene-substituted perylene, resulting from the reaction between perylene and bis(perfluorobutyryl) peroxide, thus giving wavelength-shifting film of high efficiency and light resistance, which can convert the ultraviolet zone light into the visible zone light to shift the spectroscopically sensitive zone of silicon photo-diode to longer wavelength.

US2009-0224177 A1 discloses a colour conversion member of a high efficiency achieved by restraining fluorescence emitted from a certain phosphor from being absorbed again by another different phosphor, as well as a light emitting apparatus including the colour conversion member are provided. The colour conversion member includes N light transmissive members each containing a different one of N different phosphors illuminated with excitation light to emit fluorescence in a visible wavelength region, and the N light transmissive members are stacked in order (N is a natural number of not less than two). The colour conversion member is designed in such a manner that the refractive index increases in the thickness direction while the fluorescence wavelength decreases in the thickness direction.

US 2012/060897 A1 discloses a fluorescent collector comprising at least one fluorescent dye and at least one sort of semiconductor nanoparticles and at least one photovoltaic cell for converting radiation into electrical energy.

US 2012/119639 A1 discloses luminescent converters comprising inorganic (e.g. YAG) and organic (e.g. Fumogen F) fluorescent materials.

EP 2135916 A2 discloses polymer films comprising organic and inorganic fluorescent compounds.

WO 2012/140542 A1 discloses luminescent converters comprising organic and inorganic luminescent materials.

However, modern wavelength conversion films, especially when employed for semiconductor solar cells, have to fulfil a number of requirements, which are amongst others,
- a high efficiency over a prolonged period of use,
- a high stability against thermal stress, e.g. heat or cold,
- a high stability against moisture,
- a high stability against solar irradiation,
- a high durability in an environment where it is externally exposed,
- a high efficiency over a broad range of concentrations of the fluorescent compounds dispersed in the polymer fil
- low reflective for solar irradiation,
- the fluorescent compounds in the film have to be homogeneously dispersed,
- the converted wavelength should efficiently match the wavelength of the main absorption peak of the applied semiconductor material, and
- the method of production has to be cost efficient and suitable for a mass production process.

In view of the prior art and the above-mentioned requirements on such materials, there is a considerable demand for new or alternative materials, which preferably do not show the drawbacks of the wavelength conversion films of prior art or even if do so, to a less extend.

### SUMMARY OF THE INVENTION

Surprisingly, the inventors have found that a polymer film comprising at least one inorganic fluorescent compound and at least one organic fluorescent compound, characterized in that the concentration of the inorganic compound in the polymer film varies from a high concentration on one (upper) side of the polymer film to a low concentration on the opposite (lower) side of the polymer film, whereas the concentration of the organic fluorescent compound in the polymer film varies in contrary from a low concentration on the one (upper) side of the polymer film to a high concentration on the opposite (lower) side of the polymer film, which preferably improves one or more of the above-mentioned requirements or even more preferably fulfils all above-mentioned requirements at the same time.

Thus, the present invention relates to a polymer film comprising at least one inorganic fluorescent compound and at least one organic fluorescent compound, characterized in that the concentration of the inorganic compound in the polymer film varies from a high concentration on one (upper) side of the polymer film to a low concentration on the opposite (lower) side of the polymer film, whereas the concentration of the organic fluorescent compound in the polymer film varies in contrary from a low concentration on the one (upper) side of the polymer film to a high concentration on the opposite (lower) side of the polymer film.

The polymer film according to the present invention comprises a combination of an inorganic fluorescent compound with an absorption peak in a short wavelength region of the solar irradiation including ultraviolet light, and an organic fluorescent compound with an excellent colour development property in a long wavelength region.

Therefore, the invention also relates to the use of the polymer film as a wavelength conversion film, converting radiation of a wavelength of approximately less than 500 nm into radiation of a wavelength of approximately more than 500 nm, which is more matching to the main absorption wavelength range of a suitable semiconductor material such as poly-crystalline silicon, amorphous silicon (a-Si), monocrystalline silicon (c-Si), multicrystalline silicon (mc-Si), cadmium telluride (CdTe), copper indium gallium selenide (CIGS) or gallium arsenide (GaAs).

Hence, the invention also relates to a method of improvement of a solar cell by applying a polymer film, being capable of increasing the light utilization efficiency and improving the power-generating efficiency by converting shortwave mismatching parts of the solar irradiation into a wavelength range more matching the main absorption wavelength range of the semiconductor material.

Consequently, the invention also relates to a solar cell comprising one or more semiconductor materials and a polymer film according to the present invention.

### DEFINITION OF TERMS

As used herein, the term "polymer" will be understood to mean a molecule that encompasses a backbone of one or more distinct types of repeating units (the smallest constitutional unit of the molecule) and is inclusive of the commonly known terms "oligomer", "copolymer", "homopolymer" and the like. Further, it will be understood that the term polymer is inclusive of, in addition to the polymer itself, residues from initiators, catalysts, and other elements attendant to the synthesis of such a polymer, where such residues are understood as not being covalently incorporated thereto. Further, such residues and other elements, while normally removed during post polymerisation purification processes, are typically mixed or co-mingled with the polymer such that they generally remain with the polymer when it is transferred between vessels or between solvents or dispersion media.

The term "fluorescence" means the physical process of light emission by a substance that has absorbed light or other electromagnetic radiation. It is a form of luminescence. In most cases, the emitted light has a longer wavelength, and therefore lower energy, than the absorbed radiation.

The term "organic compound" means a substance whose molecules contain one or more carbon atoms covalently bonded with another element or radical including hydrogen, nitrogen, oxygen, the halogens as well as phosphorus, silicon and sulfur.
A few exceptions are carbon monoxide, carbon dioxide, carbonates, cyanides, cyanates, carbides, and thiocyanates, which are considered inorganic.

The term "inorganic compound" means any compound not containing carbon atoms or any compound that containing carbon atoms ionically bound to other atoms such as carbon monoxide, carbon dioxide, carbonates, cyanides, cyanates, carbides, and thiocyanates.

The term "polymerization" means the chemical process to form a polymer by bonding together multiple polymerizable groups or polymer precursors (polymerizable compounds) containing such polymerizable groups. The term "polymer film" includes rigid or flexible, self-supporting or freestanding films with mechanical stability, as well as coatings or layers on a supporting substrate or as a multilayered structure on another polymer layer.

The term "absorption" means the absorbance of a material, which corresponds to the logarithmic ratio of the radiation falling upon a material, to the radiation transmitted through a material.

The term "emission" means the emission of electromagnetic waves by electron transitions in atoms and molecules.

A quantum dot is a portion of matter (e.g., semiconductor) whose excitons are confined in all three spatial dimensions. Such materials have electronic properties intermediate between those of bulk semiconductors and those of discrete molecules.

Nano-sized particles or nanoparticles are sized between 100 and 1 nanometers.

A photopolymerizing polymer, or photosetting resin, consists of photo polymerizable monomers or oligomers. The photosetting resin is exposed to electromagnetic radiation to cure.

The term "thermopolymerizable polymer", or "thermosetting resin" means a material that cures when heated and cannot be remolded.

The term "thermoplastic material" means a polymer that becomes pliable or moldable above a specific temperature, and returns to a solid state upon cooling.

The term "transmittance" means the part of incident light (or other electromagnetic radiation) at a specified wavelength that passes through a material.

Polymerizable compounds with one polymerizable group are also referred to as "monoreactive" or "monofunctional" polymer precursors, compounds with two polymerizable groups as "direactive" or "difunctional" compounds, and compounds with more than two polymerizable groups as "multireactive" or "polyfunctional" compounds. Compounds without a polymerizable group are also referred to as "non-reactive or non-polymerizable "compounds.

### DETAILED DESCRIPTION OF THE EMBODIMENTS

In one embodiment of the present invention, the polymer film comprises an inorganic fluorescent compound, which absorbs radiation with a maximum absorption peak wavelength in the range from approximately 200 to approximately 500 nm, preferable from approximately 225 to approximately 450 nm, more preferable from about 250 to approximately 425 nm, and emits with a maximum emitting peak wavelength in the range from approximately 500 to approximately 1000 nm , preferable from approximately 550 to approximately 900 nm, more preferable from approximately 450 nm to approximately 800 nm.

Suitable inorganic fluorescent materials are well known to the skilled person and described e.g. W. M. Yen, S. Shionoya and H. Yamamoto: Phosphor Handbook, 2nd Edition (CRC Press, 2006) pp. 155-338.

As known to the skilled person, the quantum efficiency of an inorganic fluorescent material decreases as the phosphor size decreases. Therefore, a suitable inorganic fluorescent material should exhibit preferably a quantum efficiency of at least 20%, more preferably of at least 30%, even more preferably at least 40%.

The particle size of suitable phosphors particles ranges from approximately 1 to approximately 100 nm, more preferable from approximately 3 to approximately 50 nm, and most preferable from approximately 5 to approximately 25 nm.

The inorganic fluorescent compounds are preferably used as nearly spherical fine particles. Moreover, examples of the shape of the inorganic fluorescent compound include,
- one grown into a column or wire shape;
- one in which two or more wire-shaped members are grown from a single point, including one of a tetrapod shape;
- one formed into a dendritic shape;
- one grown into a polyline shape;
- one grown into a mesh shape; and
- one grown into a string of beads shape.
Further, the wire-shaped catalyst itself may have a hollow shape (tubular shape) or a plate shape.

In a preferred embodiment, the inorganic fluorescent materials are selected from sulfides, thiogallates, nitrides, oxy-nitrides, silicates, aluminates, apatites, borates, oxides, phosphates, halophosphates, sulfates, tungstenates , tantalates, vanadates, molybdates, niobates, titanates, germanates or halides based phosphors, more preferably selected from the group of sulfides, thiogallates, nitrides, oxy-nitrides, silicates, aluminates, apatites oxides and vanadate based phosphors, and most preferably from the group of Y₂O₃:Bi³⁺,Eu³⁺; Y₂O₃:Bi³⁺,Eu³⁺; Y₂O₃:Bi³⁺,Eu³⁺; Y₂O₃:Ce³⁺,Tb³⁺; Y₂O₃:Ce³⁺,Tb³⁺, Y₂O₃:Ce³⁺,Tb³⁺; Y₂O₃:Bi³⁺, Eu³⁺, Y₂O₃:Ce³⁺ Y₂O₃:Ce³⁺,Tb³⁺, Y₂O₃:Ce³⁺,Tb³⁺; YVO₄:Yb³⁺, YVO₄: Eu³⁺ or YVO₄: Eu³⁺, Bi³⁺ based phosphors.

All above-mentioned inorganic fluorescent compounds or phosphors are either commercially available or can be synthesized in analogy or in accordance to methods known by the skilled artisan or as described in W. M. Yen, S. Shionoya and H. Yamamoto: Phosphor Handbook, 2nd Edition (CRC Press, 2006) pp. 341-420.

Obligatorily, the polymer film according to the present invention comprises an organic fluorescent compound.

In a preferred embodiment of the present invention, said organic fluorescent compound absorbs radiation with a maximum absorption peak wavelength in the range from approximately 350 to approximately 500 nm, more preferably from approximately 375 to approximately 500 nm, even more preferably from approximately 400 nm to 500 nm and emits radiation with a maximum emitting peak wavelength in the range from approximately 500 nm to approximately 1000nm, preferably from approximately 550 nm to 900 nm and more preferably from approximately 600 nm to 800 nm.

Suitable organic fluorescent compounds are well known to the skilled person and described e.g. in W. M. Yen, S. Shionoya and H. Yamamoto: Phosphor Handbook, 2nd Edition (CRC Press, 2006) pp. 769-774.

The organic fluorescent material should preferably exhibit a quantum efficiency of at least 80% and more preferably of at least 90%.

In a preferred embodiment, the organic fluorescent compounds are selected from Fluoresceins, Rhodamines, Coumarines, Pyrenes, Cyanines, Perylenes, Di-cyano-methylenes, rare earth metal complexes or transition metal complexes and more preferable selected from commercially available Perylenes, such as Lumogen-F570; Rhodamines, such as Rhodamine 6G; Coumarines, such as Coumarin 153 or Coumarin 6; the group of DY-707, 730, 732 and 750 by Funakoshi Ltd.; NK-3590 by Hayashibara Ltd.; and the group of LDS698, 720, 730, 750 and 765 by Exciton.

All above-mentioned organic fluorescent compounds or phosphors are either commercially available or can be synthesized in analogy or in accordance to methods known by the skilled artisan.

The inorganic fluorescent compound is preferably selected in dependence to the organic fluorescent compound with respect to their absorption characteristics. In this regard, it is preferred that the inorganic fluorescent compound has its maximum absorption peak wavelength in the region of approximately 200 to 400 and the organic compound has its maximum absorption peak wavelength in the region of approximately 400 to 800 nm of the solar radiation spectrum.

The absorption spectra of both the inorganic fluorescent compound and the organic fluorescent compound, preferably overlap less than 40 area percent, more preferable less than 20 area percent even more preferable less than 5 area percent. It is furthermore preferred that the emissions spectra of the inorganic fluorescent compound and the absorption spectra of the organic fluorescent compound overlap more than 90 area percent, preferable more than 60 area percent, more preferable more than 30 area percent and most preferable more than 10 area percent.

In particular, preferred combinations of suitable inorganic fluorescent compounds and suitable organic fluorescent compounds are given in the following table without limiting the present invention to those particular preferred combinations.

| **Inorganic fluorescent compound** | **Organic fluorescent compound** |
|---|---|
| YVO₄:Bi³⁺,Eu³⁺ | Coumarin 153 |
| YVO₄:Bi³⁺,Eu³⁺ | Coumarin 6 |
| YVO₄:Bi³⁺,Eu³⁺ | Lumogen-F570 |
| YVO₄:Bi³+,EU³⁺ | Rhodamine 6G |
| YVO₄:C^{e3}+,T^{b3+} | Coumarin 153 |
| YVO₄:Ce³⁺,Tb³⁺ | Coumarin 6 |
| YVO₄:Ce³⁺,Tb³⁺ | Lumogen-F570 |
| YVO₄:Ce³⁺,Tb³⁺ | Rhodamine 6G |
| Y₂O₃:Bi³⁺,Eu³⁺ | Coumarin 153 |
| Y₂O₃:Bi³⁺,Eu³⁺ | Coumarin 6 |
| Y₂O₃:Bi³⁺,Eu³⁺ | Lumogen-F570 |
| Y₂O₃:Bi³⁺,Eu³⁺ | Rhodamine 6G |
| Y₂0₃:Ce³⁺,Tb³+ | Coumarin 153 |
| Y₂O₃:Ce³⁺,Tb³⁺ | Coumarin 6 |
| Y₂O₃:Ce³⁺,Tb³⁺ | Lumogen-F570 |
| Y₂O₃:Ce³⁺,Tb³⁺ | Rhodamine 6G |

In another embodiment, the polymer film according the present application comprises a fluorescent semiconductor quantum dot.

A polymer film according to the present invention is obtainable from a dispersion comprising at least one of the above-described fluorescent compounds and a suitable dispersion medium.

Preferred dispersion media and/or resulting polymer films of that dispersion media should fulfill the following criteria, and should preferably exhibit
- a suitable refractive index
- a suitable transmittance for radiation between 200 and 1200 nm,
- a low yellowness index
- a high stability against thermal stress, e.g. heat or cold,
- a high stability against moisture,
- a high stability against solar irradiation,
- a high durability in an environment where it is externally exposed, and
- suitable adhesiveness properties concerning a variety of substrates.

A suitable resin for the resulting polymer film exhibits high values for the transmittance for radiation between 200 and 1200 nm, preferably between approximately 250 and 1200 nm, more preferably between approximately between 300 and 1200 nm, and is selected with regards to the absorption characteristics of the inorganic fluorescent compound.

In this context, the term high transmittance means, more than 90 % of the incident light can pass through the pure resin without any additives, preferably more than 70%, more preferably more than 50%.

The refractive index n of an optical medium or here the dispersion medium is a number that describes how light, or any other radiation, propagates through that medium. Its most elementary occurrence is in Snell's law of refraction, *n*₁ sin*θ*₁= *n*₂ sin*θ*₂, where θ₁ and θ₂ are the angles of incidence of a ray crossing the interface between two media with refractive indices *n*₁ and *n₂.*

The dispersion medium exhibits preferably a value for the refractive index between 1.35 and 1.70, more preferably between 1.40 and 1.60.

The yellowness index is a number calculated from spectrophotometric data that describes the change in color of a test sample from clear or white toward yellow. This test is commonly used to evaluate color changes in a material caused by real or simulated outdoor exposure.

A suitable dispersion medium for the resulting polymer film exhibits preferably a value for the yellowness be less than 30, preferably less than 15, and even more preferably less than 10. The yellowness index is thereby determined in conformity with ASTM E313:2005.

In one embodiment of the present invention, the dispersion medium comprise an organic/inorganic hybrid resin, preferably selected from titanium oxide-based hybrid resins, more preferably selected from those disclosed in the Japanese Patent Applications JP 2008-297537 A1 and JP 2008-255124 A1.

Preferably, those described organic/inorganic hybrid resin comprises
(A) a metal that contains an highly refractive intermediate;
(B) a polymer or oligomer; and/or
(C) a reactive monomer.

Component (A) can be obtained via the partial hydrolysis and condensation of titanium alkoxide, diethanolamine and water. Alternatively, component (A) can also be obtained via the partial hydrolysis and condensation of titanium alkoxide, an amino alcohol and water.

In another embodiment, the polymer film is obtainable from a dispersion medium comprising a photosetting resin or a thermosetting resin or a thermoplastic resin.

Suitable photosetting resins comprise at least one mono-, di- or polyfunctional photopolymerizable polymer precursor.

Preferably, the photosetting resin comprises one or more monofunctional polymer precursors and one or more di- or polyfunctional photopolymerizable polymer precursors.

The mono-, di- or polyfunctional photopolymerizable precursors are preferably selected from acrylic acid derivatives, methacrylic acid derivatives, vinyl derivatives, epoxy-derivatives or siloxane derivatives. Suitable monofunctional acrylic acid derivatives or methacrylic acid derivatives are selected from the group of aromatic acrylate derivatives , aromatic methacrylate derivatives, alkyl-acrylates, alkyl-methacrylates, substituted alkyl-acrylates or substituted alkyl-methacrylates and more preferably selected from benzyl acrylate, benzyl methacrylate, methylacrylate, methyl-methacrylate, ethyl-acrylate, ethyl-methacrylate, butyl-acrylate, butyl-methacrylate, 2-ethylhexyl-acrylate, 2-ethylhexyl-methacrylate and substituted-alkyl-acrylates or substituted-alkyl-methacrylates wherein the alkyl radicals are substituted by an hydroxyl-group or a halogen, such as F, Br and Cl, or S.

Suitable di- or polyfunctional photopolymerizable acrylic acid derivatives or methacrylic acid derivatives are preferably selected from the group of
- polymer precursors obtained from the reaction between polyhydric alcohol and α,β-unsaturated carboxylic acids, preferably selected from polyethylene-glycol di-(meth)acrylates (ethylene number therein are 2-14), tri-methylol propane di-(meth)acrylate, tri-methylol propane tri-(meth)acrylate, tri-methylol propane ethoxy tri-(meth)acrylate, tri-methylol propane propoxy tri-(metha)acrylate, tetra-methylol methan tri-(meth)acrylate, tetra-methylol methane tetra(metha)acrylate, polypropylene glycol di(metha)acrylates (propylene number therein are 2-14), di-penta-erythritol penta(meth)acrylate, di-penta-erythritol hexa(meth)acrylate, bis-phenol-A-polyoxyethylene di-(meth)acrylate, bis-phenol-A dioxyethylene di-(meth)acrylate, bis-phenol-A trioxyethylene di-(meth)acrylate or bis-phenol-A decaoxyethylene di-(meth)acrylate, and/or
- polymer precursors obtained from the addition of α,β-unsaturated carbonic acids and compounds having a glycidyl group, preferably selected from tri-methylol propane triglycidylether triacrylate, bis-phenol A diglycidylether diacrylate, and/or
- polymer precursors having an hydroxy and an ethylenic unsaturated group, preferably selected from esters with β-hydroxyethyl (meth)acrylate,
- polymer precursors obtained from a reaction between aromatic diisocyanates and 2-hydroxyethyl (meth)acrylate, preferably selected from Urethane (meth)acrylate and/or
- polymer precursors obtained from the reaction between tri-methyl hexamethylene di-isocyanate or cyclohexane dimethanol and 2-hydroxyethyl (meth)acrylate.

In particular, the di- or polyfunctional photopolymerizable acrylic acid derivatives or methacrylic acid derivatives are most preferably selected from tri-methylol-propane tri(meth)acrylate, Di-pentaerythritol tetra(meth)acrylate, Di-pentaerythritol hexa(meth)acrylate, Bisphenol-A polyoxyethylene dimethacrylate.

In order to adjust the refractive index of the dispersion medium the medium can also comprise brominated or sulphurated mono-, di- or polyfunctional photopolymerizable polymer precursors. Such bromine-substituted polymer precursors are preferably selected from the non-exhaustive list of New Frontier BR-31, New Frontier BR-30, New Frontier BR-42M, etc. manufactured by DAI-ICHI KOGYO SEIYAKU CO., LTD, while the sulphur-substituted polymer precursors are preferably selected from the non-exhaustive list of IU-L2000, IU-L3000, IU-MS1010, etc. manufactured by MITSUBISHI GAS CHEMICAL COMPANY, INC.

Suitable polymerizable vinyl derivatives are preferably selected from vinyl halides, acrylnitrile, vinyl amides, vinyl ethers, or aromatic vinyl derivatives more preferably selected form vinyl chloride, vinyl bromide, acryl amide, styrene, or vinyl-toluene.

A suitable dispersion medium can also comprise, preferably consists of polymerizable siloxanes. Siloxane compounds are characterized by sub units in the form of R₂SiO, where R denotes a hydrogen atom or a hydrocarbon group. Suitable polymerizable siloxanes are well known to the skilled person. However, preferred siloxanes are selected, but not limited to FX-V5500 from Adeka Corporation, A-1456 from TESK CO., LTD and OE-6665 from Dow Corning Corporation.

Preferably, all above listed polymer precursors can be used separately or in any combination with each other in a co-polymer.

A preferred photosetting resin can also comprise one or more photoinitiators, which generate free radicals when exposed to ultraviolet light (approx. 200 to 400 nm) or a visible light (approx. 400 to 800 nm).

Suitable photoinitiators are preferably selected from
- benzoin-ethers, preferably benzoin-methyl-ether, benzoin-ethylether, benzoin-propyl-ether, benzoin-isobutyl-ether, benzoin-phenyl-ether, benzoin-ethers, and/or
- benzophenones, preferably N,N'-tetramethyl-4,4'-diaminobenzophenone (Michler's-ketone), N,N'-tetraethyl-4,4'diaminobenzophenone, benzil-dimethyl-ketal (e.g. IRGACURE 651 commercially available from Ciba), and/or
- dibenzil ketals, preferably benzil-diethyl-ketal, and/or
- acetophenones, preferably 2,2-dimethoxy-2-phenylacetophenone, p-tert-butyldichloro acetophenone, p-dimethylamino acetophenone,
- thioxanthones, preferably 2,4-dimetyl thioxanthone, 2,4-diisopropyl thioxanthone, and/or
- phenone derivatives, such as hydroxy cyclohexyl phenyl ketone (e.g. IRGACURE 184 from Ciba), 1-(4-isopropylphenyl)-2-hydroxy-2-methylpropane-1-on , 2-hydroxy-2-methyl-1-phenylpropane-1-on.

The photoinitiators can be used alone or in any combination with each other.

It is also possible to add further additives such as stabilizers, adhesion promoters or surfactants or sensitizers to the photosetting resin. Sensitizers have no photo initiating ability itself, but form a sensitizer system with the above-mentioned photoinitiators. Suitable sensitizer/photoinitiator systems comprise a tertiary amines and one or more photoinitiators as described above, like for example the combination of triethanol amine and benzophenone.

Where applicable, the photosetting resin can be used as obtained from the mixture of its ingredients as a dispersion medium. It is also possible to dissolve the photosetting resin in a suitable solvent and use the corresponding solution as a dispersion medium.

In another embodiment according to the present invention, the dispersion medium comprises a thermoplastic resin which can be exposed to heat or pressure or which is used as a solution.

Suitable thermoplastic resins are well known to the skilled artisans and can comprise for example shares of natural rubber, poly-isoprene, poly 1,2-butadiene, polyisobutene, polybutene, poly-2-heptyl 1,3-butadiene, poly-2-t-butyl-1,3-butadine , poly-1,3-butadiene, polyoxyethylene, polyoxypropylene, polyvinylethyl ether, polyvinylhexyl ether, polyvinylbutyl ether, poly vinyl acetate, poly vinyl propionate, poly urethane, ethyl cellulose, poly vinyl chloride, poly acrylo nitrile, poly methacrylonitrile, poly sulfone, poly sulphide, phenoxy resins, polyethylacrylate, polybutylacrylate, poly-2-ethylhexyl acrylate, poly-t-butyl acrylate, poly-3-ethoxypropylacrylate,polyoxycarbonyl tetra-methacrylate, polymethylacrylate, polyisopropylmethacrylate, polydodecyl methacrylate, polytetradecyl methacrylate, poly-n-propyl methacrylate, poly-3,3,5-trimethylcyclohexyl methacrylate, polyethylmethacrylate, poly-2-nitro-2-methylpropylmethacrylate, poly-1,1-diethylpropyfmethacrylate or poly(meth)acrylates, such as polymethylmethacrylate.

It is also possible to co-polymerize two or more polymer precursors, in order to adjust the physical characteristics of a corresponding thermoplastic resin that are amongst others the softening point or the adhesiveness of the resin.

Suitable thermoplastic co-polymers according to the present invention are preferably selected from the group of derivates having an acrylate functional group, preferably urethane acrylates, and/or epoxy acrylates, and/or polyether acrylates, and/or polyester acrylates, more preferably selected from urethane acrylates and/or epoxy acrylates and/or polyether acrylates and even more preferably selected from the group of epoxy acrylates.

It is also possible to add further additives to the thermoplastic resin such as plasticizers, flame retardants and stabilizers.

The softening point of a thermoplastic resin according to the present invention is preferably less than 200°C, more preferably less than 150°C even more preferably less than 120°C but in all cases not lower than 80°C.

In a polymer film according to the present invention, preferably, the concentration of the inorganic compound in the polymer film varies from a high concentration on one (upper) side of the polymer film to a low concentration on the opposite (lower) side of the polymer film, whereas the concentration of the organic fluorescent compound in the polymer film varies in contrary from a low concentration on the one (upper) side of the polymer film to an high concentration on the opposite (lower) side of the polymer film.

Having such structure, it is possible that the inorganic fluorescent compound which has an high concentration on the upperside of the polymerfilm, to absorb the incident light in the short wavelength region as described above, such as UV light and thereby reducing, preferably eliminating any photochemical effects of the short wavelength light on the organic fluorescent compound, such as decomposition, photoreaction, etc.

Such a polymer film according to the present invention includes either a multilayer structure comprising two, three, four, or more different sub layers, or a single layer structure. Preferred structures of the polymer film are given in the following list:
a) Polymer film comprising, preferably consisting of one layer which comprises a mixture of one or more organic and on or more inorganic fluorescent compounds, wherein the concentration of the inorganic compound(s) in the resulting polymer film varies from a high concentration on one (upper) side of the polymer film to a low concentration on the opposite (lower) side of the polymer film, whereas the concentration of the organic fluorescent compound(s) in resulting polymer film varies in contrary from a low concentration on the one (upper) side of the polymer film to an high concentration on the opposite (lower) side of the polymer film, or
b) Polymer film comprising, preferably consisting of two sub layers, wherein a first base layer comprises one or more organic fluorescent compounds and no inorganic fluorescent compound and a second cover layer comprises one or more inorganic fluorescent compound(s) and no organic fluorescent compound, or
c) Polymer film comprising, preferably consisting of three sub layers, wherein a first base layer comprises one or more organic fluorescent compounds and no inorganic fluorescent compound; a second or middle sub layer comprises a mixture of one or more organic fluorescent compounds and one or more inorganic fluorescent compounds, wherein the concentration of the inorganic compound(s) in the sub layer varies from a high concentration on one (upper) side of the sub layer to a low concentration on the opposite (lower) side of the sub layer, whereas the concentration of the organic fluorescent compounds in the sub layer varies in contrary from a low concentration on the one (upper) side of the sub layer to a high concentration on the opposite (lower) side of the sub layer; and a third or cover layer comprising one or more inorganic fluorescent compounds and no organic fluorescent compound.
d) Polymer film comprising, preferably consisting of four sub layers, wherein a first or base layer comprises one or more organic fluorescent compounds no inorganic fluorescent compound; a second or lower middle sub layer comprises a mixture of one or more organic fluorescent compounds and one or more inorganic fluorescent compounds, wherein the amount of organic fluorescent compounds is higher than the amount of inorganic fluorescent compounds; a third or upper middle sub layer comprises a mixture of one or more organic fluorescent compounds and one or more inorganic fluorescent compounds, wherein the amount of inorganic fluorescent compounds is higher than the amount of organic fluorescent compounds; and a fourth or cover layer comprises one or more inorganic fluorescent substance and no organic fluorescent compound.

The method of production of a polymer film according to the present invention depends on the structure of the polymer film itself (one layered structure or multilayered structure) or the composition of the applied dispersion medium.

Generally, the method of production of a polymer film according to present invention comprises in each case the steps of
- providing a layer of a mixture comprising a dispersion medium and at least one organic fluorescent compound on a substrate;
- curing of said mixture, and
- optionally, removing the polymer film from the substrate.

If the polymer film or one of its sub layer(s) applies a concentration gradient of the applied fluorescent compounds, the corresponding organic and inorganic fluorescent compounds are firstly homogenously dispersed in a suitable dispersion medium as described above.

The concentration of the inorganic fluorescent compound in the medium as a whole, is preferably between 0.01wt% and 10wt%, and more preferably between 0.5wt% and 5wt%, whereby the concentration of the organic fluorescent compound in the medium as a whole, is preferably between 0.01wt% and 10wt%, and more preferably between 0.05wt% and 0.5wt%.

If the polymer film or one of its sub layer(s) do not applies a concentration gradient of the fluorescent compounds, the corresponding organic or the corresponding inorganic fluorescent compound is homogenously dispersed in a suitable dispersion medium as described above.

The concentration of the inorganic fluorescent compound in the medium as a whole, is preferably between 0.01wt% and 10wt%, and more preferably between 0.5wt% and 5wt%.

The concentration of the organic fluorescent compound in the medium as a whole, is preferably between 0.01wt% and 10wt%, more preferably between 0.01wt% and 5wt%, and most preferably between 0.05wt% and 0.5wt%.

The method for providing the corresponding mixtures onto a suitable substrate is not limited in any particular way and any known wet film forming methods can be employed. However, preferred methods include spin coating, ink jet, slit coating, intaglio printing, relief printing, planography, silk screen printing and dye coating procedures.

The layer thickness is preferably between 0.1 µm and 3000µm, more preferably between 1 pm and 500pm, and even more preferably between 10µm and 200pm.

Suitable substrates are glass substrates, plastic film substrates such as polystyrene, polyvinyl chloride, polyethylene terephthalate, polypropylene, polyethylene, acrylonitrile butadiene styrene, polycarbonate, polymethyl methacrylate, semiconductor material substrates or even another polymer film or a sub layer of such a polymer film of the present application.

If a concentration gradient is required, a waiting time after coating or printing of the mixture comprising a photosetting resin, at least one organic fluorescent compound and at least one inorganic fluorescent compound until immobilization by baking of the mixture, allows that the organic fluorescent compound(s) and the inorganic fluorescent compound(s) separate from each other due to their different particle sizes and masses.

The preferred time range depends mainly on the viscosity of the dispersion medium and the particle density and can thereby easily be adjusted from case to case by the skilled person without the need of excessive trails and errors.

If a photosetting dispersion medium is applied, an immobilization by baking is conducted immediately after coating or in case of a concentration gradient, when the desired condition is reached, thereby immobilizing the film.

Baking is preferably conducted above 60°C, more preferably above 80°C and even more preferably above 100°C.
In case another suitable and above described dispersion medium is applied, the immobilization step is redundant since a curing with exposure to heat or cooling will finalize the procedure.

The dispersion medium is cured under suitable conditions known by the skilled person concerning the applied dispersion medium. The curing step can thereby comprise the methods of exposure of the uncured film to actinic irradiation such as UV light, in case a photosetting resin is applied; cooling in case a thermoplastic resin is applied and heating if the applied dispersion medium corresponds to a thermosetting resin.

It is also possible to apply an additional protective layer and/or a structured layer, e.g. a Fresnel lens structured layer, on top of the polymer film according to the present invention.

The invention also relates to the use of the polymer film as a wavelength conversion film, converting radiation of a wavelength of approximately less than 500 nm into radiation of a wavelength of approximately more than 500 nm which is utilized effectively by a variety of semiconductor materials in solar cells.

In this regard, the maximum absorption wavelength-of for example an amorphous silicon solar cell is around 600 nm and of a single crystal silicon solar cell around 800 nm. It is a matter of fact, that the radiation utilized effectively in the photoelectric conversion is restricted to the radiation in the longer wavelength region of 500 nm and more.

For the purpose of allowing light in a short wavelength region of the solar light, which has also a high energy and which should preferably be also utilized effectively, the polymer film according to the present invention allows the conversion of radiation of a wavelength lower than 500 nm and less to radiation having a wavelength higher than 500 nm and more, which than can be subjected to a photoelectric conversion by the solar cell.

Thus, the invention relates also to a method of improvement of a solar cell module by applying a polymer film according to the present invention, which is capable to increase the light utilization efficiency and the power-generating efficiency, due to a wavelength conversion of the shortwave part of the solar irradiation spectrum which normally cannot be utilized due to the absorption characteristics of the semiconductor material in the solar cell module.

Hence, the invention relates also to the use of a polymer film in a solar cell module.

The exact structure of suitable solar cells is known by the persons skilled in the art. For example, polycrystalline silicon wafers, made from wire-sawing block-cast silicon ingots, are sliced into very thin wafers of approximately 180 to 350 micrometer. The wafers are usually lightly p-type doped. To make a solar cell from the wafer, a surface diffusion of n-type dopants is performed on the front side of the wafer. This forms a p-n junction, a few hundred nanometers below the surface. It is also possible to apply anti-reflection coatings made of silicon nitride or titanium dioxide, to increase the amount of light coupled into the solar cell, which are typically applied in a layer several hundred nanometers thick using plasma-enhanced chemical vapor deposition (PECVD). Preferred solar cells have beside the polymer film according to the present invention also a textured front surfaces like for example in shape of a Fresnel lens and/or anti-reflection coatings, serve to increase the amount of light coupled into the cell. Such surfaces are usually being formed on single-crystal silicon but also other semiconductor materials are possible. The wafer then has a full area metal contact made on the back surface, and a grid-like metal contact made up of fine "fingers" and larger "bus bars" are screen-printed onto the front surface using a silver paste. The rear contact is also formed by screen-printing a metal paste, typically aluminum. Usually this contact covers the entire rear side of the cell, though in some cell designs it is printed in a grid pattern. The paste is then fired at several hundred degrees Celsius to form metal electrodes in ohmic contact with the silicon. Also the use of an additional electro-plating step to increase the cell efficiency is possible.

Beside the above mentioned poly-crystalline silicon wafers, suitable solar cell modules, can also comprise other preferred semiconductor material which selected from amorphous silicon (a-Si), monocrystalline silicon (c-Si), multicrystalline silicon (mc-Si), cadmium telluride (CdTe), copper indium gallium selenide (CIGS) or gallium arsenide (GaAs).
Accordingly, the instant application also relates to a method of production of a solar cell module comprising the step of providing a polymer film according to the present invention onto a solar cell.

The present invention is described above and below with particular reference to the preferred embodiments.

Many of the compounds or mixtures thereof mentioned above and below are commercially available. The organic compounds are either known or can be prepared by methods which are known per se, as described in the literature (for example in the standard works such as Houben-Weyl, Methoden der Organischen Chemie [Methods of Organic Chemistry], Georg- Thieme-Verlag, Stuttgart), to be precise under reaction conditions which are known and suitable for said reactions. Use may also be made here of variants which are known per se, but are not mentioned here. Unless the context clearly indicates otherwise, as used herein plural forms of the terms herein are to be construed as including the singular form and vice versa.

Throughout this application, unless explicitly stated otherwise, all concentrations are given in weight percent and relate to the respective complete mixture, all temperatures are given in degrees centigrade (Celsius) and all differences of temperatures in degrees centigrade. Throughout the description and claims of this specification, the words "comprise" and "contain" and variations of the words, for example "comprising" and "comprises", mean "including but not limited to", and are not intended to (and do not) exclude other components. On the other hand, the word "comprise" also encompasses the term "consisting of' but is not limited to it.

It will be appreciated that variations to the foregoing embodiments of the invention can be made while still falling within the scope of the invention. Each feature disclosed in this specification, unless stated otherwise, may be replaced by alternative features serving the same, equivalent or similar purpose. Thus, unless stated otherwise, each feature disclosed is one example only of a generic series of equivalent or similar features.

All of the features disclosed in this specification may be combined in any combination, except combinations where at least some of such features and/or steps are mutually exclusive. In particular, the preferred features of the invention are applicable to all aspects of the invention and may be used in any combination. Likewise, features described in non-essential combinations may be used separately (not in combination).

It will be appreciated that many of the features described above, particularly of the preferred embodiments, are inventive in their own right and not just as part of an embodiment of the present invention. Independent protection may be sought for these features in addition to or alternative to any invention presently claimed.

The features of the invention are summarized in form of a numbered list:
1. A polymer film comprising at least one inorganic fluorescent compound and at least one organic fluorescent compound, characterized in that the concentration of the inorganic compound in the polymer film varies from a high concentration on one (upper) side of the polymer film to a low concentration on the opposite (lower) side of the polymer film, whereas the concentration of the organic fluorescent compound in the polymer film varies in contrary from a low concentration on the one (upper) side of the polymer film to a high concentration on the opposite (lower) side of the polymer film.

### Preferred features

2. The polymer film according to note 1, characterized in that the inorganic fluorescent compound absorbs radiation with a maximum absorption peak wavelength in the range from 250 to 400 nm and emits radiation with a maximum emitting peak wavelength in the range from 500 to 1000 nm.
3. The polymer film according to note 1 or 2, characterized in that the organic fluorescent compound absorbs radiation with a maximum absorption peak wavelength in the range from 300 to 500 nm and emits radiation with a maximum emitting peak wavelength in the range from 500 to 1000 nm.
4. The polymer film according to one or more of notes 1 to 3, characterized in that the inorganic fluorescent compound is selected from the group of sulfides, thiogallates, nitrides, oxy-nitrides, silicates, aluminates, apatites, borates, oxides, phosphates, halophosphates, sulfates, tungstenates , tantalates, vanadates, molybdates, niobates, titanates, germanates or halides based phosphors.
5. The polymer film, according to one or more of the notes 1 to 4, characterized in that the inorganic fluorescent compound has a particle size in the range from 1 to 100 nm.
6. The polymer film according to one or more of notes 1 to 5, characterized in that the organic fluorescent compound is selected from Fluoresceins, Rhodamines, Coumarins, Pyrenes, Cyanines, Perylenes or Di-cyano-methylenes.
7. The polymer film, according to one or more of the notes 1 to 6, characterized in that it comprises a fluorescent semiconductor quantum dot.
8. The polymer film according to one or more of notes 1 to 7, characterized in that it comprises a photosetting resin, and/or a thermosetting resin, and/or a thermoplastic resin with suitable transmittance values for radiation between 200 and 1200 nm.
9. Method of production of a polymer film according to one or more of notes 1 to 8, characterized in that it comprises the steps of
   - providing at least one layer of a mixture comprising at least one dispersion medium and at least one organic fluorescent compound on a substrat
   - curing of said mixture and, optionally,
   - removing the polymer film from the substrate.
10. Use of the polymer film according to one or more of notes 1 to 8 as a wavelength conversion film, converting radiation of a wavelength of approximately less than 500 nm into radiation of a wavelength in the range of approximately more than 500 nm.
11. Use of a polymer film according to note 10 in a solar cell.
12. Solar cell comprising a polymer film according to one or more of notes 1 to 8.
13. Solar cell according to note 12, characterized in that the module comprises at least one layer selected from amorphous silicon (a-Si), monocrystalline silicon (c-Si), polycrystalline silicon (poly-Si), multicrystalline silicon (mc-Si), cadmium telluride (CdTe), copper indium gallium selenide (CIGS) or gallium arsenide (GaAs).
14. Method of production of a solar cell according to note 12 or 13, by providing the polymer film according to one or more of notes 1 to 8 onto a solar cell.

The invention will now be described in more detail by reference to the following examples, which are illustrative only and do not limit the scope of the invention.

### Examples

The examples below illustrate the present invention without limiting it in any way.

### Example 1 - Synthesis of YVO₄ -based phosphor

A mixture of 0.91 g of sodium oleate (3 mmol) and 0.4 g of Na3VO4*12H2O (1 mmol) in 15 mL of deionized water are gradually stirred into a solution of 2 mL oleylamine in 8 mL of ethanol and then stirred together for 20 min. Next, a mixture of ethylene glycol and Bismuth nitrate pentahydrate as well as a solution of 0.38 g Y(NO3)3 (1 mmol) and 0.04 g (0.2 mmol) of europium acetate tetrahydrate in 8 ml water are added to this mixture, and the resulting milky mixture is transferred into an autoclave and stirred for another 10 min. The autoclave is sealed and heated to 180 °C and stirred for 12 h under this temperature. After cooling to room temperature, the resulting white suspension is centrifuged for 10 min at 5000 rpm, and the precipitates are thoroughly washed with ethanol and dried in the air at 60 °C.

In analogy to the above-described synthetic procedure, also other YVO₄ nanocrystals doped with lanthanide ions, such as Eu³⁺ (5%) and Bi³⁺ (3%) can be obtained.

### Example 2 - single layer polymer film

Coumarin 6 (available from Sigma-ALDRICH) and YVO₄: Eu³⁺, Bi³⁺ as synthesized above, are dispersed into photo-polymerizable siloxane FX-V5500 (available from Adeka corporation, Japan) with an amount of 0.30 wt% and 1.0 wt%, respectively. The mixture is dissolved in PGMEA to obtain a 67 wt% solution. The solution is spin-coated on a glass substrate at 1000 r.p.m. and subsequently baked at 100°C for 3min. The mixture is photo-polymerized in air using 365 nm UV lamp. The total exposure dose is 360 mJ/cm². In order to generate a concentration gradient of the film, this resultant layer is irradiated under air atmosphere using a 365 nm UV lamp for 12 hours. The film is peeled off from the glass substrate and applied on a crystal Si (c-Si) solar cell.

### Example 3 - multilayered polymer film

Coumarin 6 (available from Sigma-ALDRICH) is dispersed in photo-polymerizable siloxane FX-V5500 with a concentration of 0.3 wt%. The mixture is dissolved in PGMEA to obtain 67 wt% solution as solution A. YVO₄: Eu³⁺, Bi³⁺ of example 1 is dispersed in photo-polymerizable siloxane FX-V5500 with a concentration of 1.0 wt%. The mixture is dissolved in PGMEA to obtain 67wt% solution as solution B.

Coumarin 6 and YVO₄: Eu³⁺, Bi³⁺ are each dispersed in FX-V5500 with a concentration of 0.3 wt% and 1.0 wt%, respectively. The mixture is dissolved in PGMEA to obtain 67wt% solution as solution C.

The solution A is spin-coated on a cleaned glass substrate at 1000 r.p.m. and subsequently baked at 100°C for 3min.

Then, the solution B is spin coated on the layer derived from solution A of the glass substrate. Mixed layer was formed and subsequently baked at 100°C for 3 min.

Solution C is spin coated on the mixed layer derived from solution A and B on the glass substrate at 1000r.p.m and subsequently baked at 100°C for 3min. The combined layers are photo-polymerized in air using 365nm UV lamp. The total exposure dose is 360 mJ/cm². The film is peeled off from the glass substrate and applied on a crystal Si (c-Si) solar cell.

### Comparative example 1

A polymer film is produced in analogy to Example 2 from a dispersion of YVO₄:Eu³⁺, Bi³⁺ in photo-polymerizable siloxane FX-V5500 with a concentration of 1.0 wt% as a comparative example 1. The film is peeled off from the glass substrate and applied on a crystal Si (c-Si) solar cell.

### Comparative example 2

A polymer film is produced in analogy to Example 2 from a dispersion of Coumarin 6 in photo-polymerizable siloxane FX-V5500 with 0.3 wt% concentration as a comparative example 1. The film is peeled off from the glass substrate and applied on a crystal Si (c-Si) solar cell.

### Comparison of solar cells

Corresponding solar cells derived from the above described examples are exposed to light from a xenon lamp of 100 W. Measurement is conducted to measure values of photocurrent due to photoelectric conversion reaction occurring at this time, and the cell according to the present invention demonstrated the short-circuit current and fill factor both 5% or more than those of the cell of the comparative examples.

In conclusion, the polymer films according to Example 2 and 3 are effectively applicable to the photoelectric conversion apparatus.

## Claims

1. A polymer film comprising at least one inorganic fluorescent compound and at least one organic fluorescent compound, **characterized in that** the concentration of the inorganic compound in the polymer film varies from a high concentration on one (upper) side of the polymer film to a low concentration on the opposite (lower) side of the polymer film, whereas the concentration of the organic fluorescent compound in the polymer film varies in contrary from a low concentration on the one (upper) side of the polymer film to a high concentration on the opposite (lower) side of the polymer film.

2. The polymer film according to claim 1, **characterized in that** the inorganic fluorescent compound absorbs radiation with a maximum absorption peak wavelength in the range from 250 to 400 nm and emits radiation with a maximum emitting peak wavelength in the range from 500 to 1000 nm.

3. The polymer film according to claim 1 or 2, **characterized in that** the organic fluorescent compound absorbs radiation with a maximum absorption peak wavelength in the range from 300 to 500 nm and emits radiation with a maximum emitting peak wavelength in the range from 500 to 1000 nm.

4. The polymer film according to one or more of claims 1 to 3, **characterized in that** the inorganic fluorescent compound is selected from the group of sulfides, thiogallates, nitrides, oxy-nitrides, silicates, aluminates, apatites, borates, oxides, phosphates, halophosphates, sulfates, tungstenates, tantalates, vanadates, molybdates, niobates, titanates, germanates or halides based phosphors.

5. The polymer film, according to one or more of the claims 1 to 4, **characterized in that** the inorganic fluorescent compound has a particle size in the range from 1 to 100 nm.

6. The polymer film according to one or more of claims 1 to 5, **characterized in that** the organic fluorescent compound is selected from Fluoresceins, Rhodamines, Coumarins, Pyrenes, Cyanines, Perylenes or Di-cyano-methylenes.

7. The polymer film, according to one or more of the claims 1 to 6, **characterized in that** it comprises a fluorescent semiconductor quantum dot.

8. The polymer film according to one or more of claims 1 to 7, **characterized in that** it comprises a photosetting resin, and/or a thermosetting resin, and/or a thermoplastic resin with suitable transmittance values for radiation between 200 and 1200 nm.

9. Method of production of a polymer film according to one or more of claims 1 to 8,_**characterized in that** it comprises the steps of
- providing at least one layer of a mixture comprising at least one dispersion medium and at least one organic fluorescent compound on a substrate
- curing of said mixture and, optionally,
- removing the polymer film from the substrate.

10. Use of the polymer film according to one or more of claims 1 to 8 as a wavelength conversion film, converting radiation of a wavelength of approximately less than 500 nm into radiation of a wavelength in the range of approximately more than 500 nm.

11. Use of a polymer film according to claim 10 in a solar cell.

12. Solar cell comprising a polymer film according to one or more of claims 1 to 8.

13. Solar cell according to claim 12, **characterized in that** the module comprises at least one layer selected from amorphous silicon (a-Si), monocrystalline silicon (c-Si), polycrystalline silicon (poly-Si), multicrystalline silicon (mc-Si), cadmium telluride (CdTe), copper indium gallium selenide (CIGS) or gallium arsenide (GaAs).

14. Method of production of a solar cell according to claim 12 or 13, by providing the polymer film according to one or more of claims 1 to 8 onto a solar cell.

## Patentansprüche

1. Polymerfolie enthaltend mindestens eine anorganische Fluoreszenzverbindung und mindestens eine organische Fluoreszenzverbindung, **dadurch gekennzeichnet, dass** sich die Konzentration der anorganischen Verbindung in der Polymerfolie von einer hohen Konzentration auf einer (oberen) Seite der Polymerfolie zu einer niedrigen Konzentration auf der gegenüberliegenden (unteren) Seite der Polymerfolie ändert, während sich die Konzentration der organischen Fluoreszenzverbindung in der Polymerfolie im Gegensatz dazu von einer niedrigen Konzentration auf der einen (oberen) Seite der Polymerfolie zu einer hohen Konzentration auf der gegenüberliegenden (unteren) Seite der Polymerfolie ändert.

2. Polymerfolie nach Anspruch 1, **dadurch gekennzeichnet, dass** die anorganische Fluoreszenzverbindung Strahlung mit einer Wellenlänge des maximalen Absorptionspeaks im Bereich von 250 bis 400 nm absorbiert und Strahlung mit einer Wellenlänge des maximalen Emissionspeaks im Bereich von 500 bis 1000 nm emittiert.

3. Polymerfolie nach Anspruch 1 oder 2, **dadurch gekennzeichnet, dass** die organische Fluoreszenzverbindung Strahlung mit einer Wellenlänge des maximalen Absorptionspeaks im Bereich von 300 bis 500 nm absorbiert und Strahlung mit einer Wellenlänge des maximalen Emissionspeaks im Bereich von 500 bis 1000 nm emittiert.

4. Polymerfolie nach einem oder mehreren der Ansprüche 1 bis 3, **dadurch gekennzeichnet, dass** die anorganische Fluoreszenzverbindung aus der Gruppe der auf Sulfiden, Thiogallaten, Nitriden, Oxy-nitriden, Silicaten, Aluminaten, Apatiten, Boraten, Oxiden, Phosphaten, Halogenphosphaten, Sulfaten, Wolframaten, Tantalaten, Vanadaten, Molybdaten, Niobaten, Titanaten, Germanaten oder Halogeniden basierenden Leuchtstoffe ausgewählt ist.

5. Polymerfolien nach einem oder mehreren der Ansprüche 1 bis 4, **dadurch gekennzeichnet, dass** die anorganische Fluoreszenzverbindung eine Teilchengröße im Bereich von 1 bis 100 nm aufweist.

6. Polymerfolie nach einem oder mehreren der Ansprüche 1 bis 5, **dadurch gekennzeichnet, dass** die organische Fluoreszenzverbindung aus Fluoresceinen, Rhodaminen, Cumarinem, Pyrenen, Cyaninen, Perylenen oder Di-cyano-methylenen ausgewählt ist.

7. Polymerfolie nach einem oder mehreren der Ansprüche 1 bis 6, **dadurch gekennzeichnet, dass** sie einen fluoreszierenden Halbleiter-Quantenpunkt enthält.

8. Polymerfolie nach einem oder mehreren der Ansprüche 1 bis 7, **dadurch gekennzeichnet, dass** sie ein lichthärtendes Harz und/oder ein wärmehärtendes Harz und/oder ein thermoplastisches Harz mit geeigneten Durchlässigkeitswerten für Strahlung zwischen 200 und 1200 nm enthält.

9. Verfahren zur Herstellung einer Polymerfolie nach einem oder mehreren der Ansprüche 1 bis 8, **dadurch gekennzeichnet, dass** es die Schritte
- Bereitstellen mindestens einer Schicht einer Mischung enthaltend mindestens ein Dispersionsmedium und mindestens eine organische Fluoreszenzverbindung auf einem Substrat
- Härten der Mischung und gegebenenfalls
- Entfernen der Polymerfolie von dem Substrat
umfasst.

10. Verwendung der Polymerfolie nach einem oder mehreren der Ansprüche 1 bis 8 als Wellenlängenumwandlungsfolie, die Strahlung einer Wellenlänge von ungefähr weniger als 500 nm in Strahlung einer Wellenlänge im Bereich von ungefähr mehr als 500 nm umwandelt.

11. Verwendung einer Polymerfolie nach Anspruch 10 in einer Solarzelle.

12. Solarzelle enthaltend eine Polymerfolie nach einem oder mehreren der Ansprüche 1 bis 8.

13. Solarzelle nach Anspruch 12, **dadurch gekennzeichnet, dass** das Modul mindestens eine Schicht enthält, die aus amorphem Silizium (a-Si), monokristallinem Silizium (c-Si), polykristallinem Silizium (poly-Si), multikristallinem Silizium (mc-Si), Cadmiumtellurid (CdTe), KupferIndiumGalliumselenid (CIGS) oder Galliumarsenid (GaAs) ausgewählt ist.

14. Verfahren zur Herstellung einer Solarzelle nach Anspruch 12 oder 13, durch Bereitstellen der Polymerfolie nach einem oder mehreren der Ansprüche 1 bis 8 auf einer Solarzelle.

## Revendications

1. Film en polymère comprenant au moins un composé fluorescent inorganique et au moins un composé fluorescent organique, **caractérisé en ce que** la concentration du composé inorganique dans le film en polymère varie d'une concentration élevée sur un premier côté (supérieur) du film en polymère à une concentration faible sur le côté opposé (inférieur) du film en polymère, tandis que la concentration du composé fluorescent organique dans le film en polymère varie, en sens contraire, d'une concentration faible sur le premier (supérieur) du film en polymère à une concentration élevée sur le côté opposé (inférieur) du film en polymère.

2. Film en polymère selon la revendication 1, **caractérisé en ce que** le composé fluorescent inorganique absorbe un rayonnement présentant une longueur d'onde de crête d'absorption maximum dans la plage de 250 à 400 nm et émet un rayonnement présentant une longueur d'onde de crête d'émission maximum dans la plage de 500 à 1000 nm.

3. Film en polymère selon la revendication 1 ou 2, **caractérisé en ce que** le composé fluorescent organique absorbe un rayonnement présentant une longueur d'onde de crête d'absorption maximum dans la plage de 300 à 500 nm et émet un rayonnement présentant une longueur d'onde de crête d'émission maximum dans la plage de 500 à 1000 nm.

4. Film en polymère selon une ou plusieurs des revendications 1 à 3, **caractérisé en ce que** le composé fluorescent inorganique est choisi parmi le groupe constitué par les sulfures, les thiogallates, les nitrures, les oxynitrures, les silicates, les aluminates, les apatites, les borates, les oxydes, les phosphates, les halophosphates, les sulfates, les tungsténates, les tantalates, les vanadates, les molybdates, les niobates, les titanates, les germanates ou les phosphores à base d'halogénures.

5. Film en polymère selon une ou plusieurs des revendications 1 à 4, **caractérisé en ce que** le composé fluorescent inorganique présente une taille de particule dans la plage de 1 à 100 nm.

6. Film en polymère selon une ou plusieurs des revendications 1 à 5, **caractérisé en ce que** le composé fluorescent organique est choisi parmi les fluorescéines, les rhodamines, les coumarines, les pyrènes, les cyanines, les pérylènes ou les dicyanométhylènes.

7. Film en polymère selon une ou plusieurs des revendications 1 à 6, **caractérisé en ce qu'**il comprend un point quantique semiconducteur fluorescent.

8. Film en polymère selon une ou plusieurs des revendications 1 à 7, **caractérisé en ce qu'**il comprend une résine photodurcissable et/ou une résine thermodurcissable et/ou une résine thermoplastique présentant des valeurs de transmittance appropriées pour un rayonnement entre 200 et 1200 nm.

9. Procédé de production d'un film en polymère selon une ou plusieurs des revendications 1 à 8, **caractérisé en ce qu'**il comprend les étapes consistant à :
- produire au moins une couche d'un mélange comprenant au moins un milieu de dispersion et au moins un composé fluorescent organique sur un substrat ;
- durcir ledit mélange et, en option,
- enlever le film en polymère du substrat.

10. Utilisation du film en polymère selon une ou plusieurs des revendications 1 à 8 en tant que film de conversion de longueur d'onde, qui convertit un rayonnement d'une longueur d'onde environ inférieure à 500 nm selon un rayonnement d'une longueur dans la plage d'environ plus de 500 nm.

11. Utilisation d'un film en polymère selon la revendication 10 dans une cellule solaire.

12. Cellule solaire comprenant un film en polymère selon une ou plusieurs des revendications 1 à 8.

13. Cellule solaire selon la revendication 12, **caractérisée en ce que** le module comprend au moins une couche choisie parmi le silicium amorphe (a-Si), le silicium monocristallin (c-Si), le silicium polycristallin (poly-Si), le silicium multicristallin (mc-Si), le tellurure de cadmium (CdTe), le séléniure de cuivre, d'indium et de gallium (CIGS) ou l'arséniure de gallium (GaAs).

14. Procédé de production d'une cellule solaire selon la revendication 12 ou 13, en produisant le film en polymère selon une ou plusieurs des revendications 1 à 8 sur une cellule solaire.
